(19) Europäisches Patentamt
European Patent Office
Office européen des brevets

(11) **EP 4 657 023 A1**

(12) **EUROPEAN PATENT APPLICATION**

(43) Date of publication:
03.12.2025 Bulletin 2025/49

(21) Application number: 25172224.5

(22) Date of filing: 24.04.2025

(51) International Patent Classification (IPC):
*G01C 21/34* (2006.01)

(52) Cooperative Patent Classification (CPC):
G01C 21/3423; G01C 21/3484

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 28.05.2024 JP 2024086161

(71) Applicant: FUJITSU LIMITED
Kawasaki-shi, Kanagawa 211-8588 (JP)

(72) Inventors:
• ZHANG, Jiachao
Kawasaki-shi, Kanagawa, 211-8588 (JP)
• FUJITA, Takushi
Kawasaki-shi, Kanagawa, 211-8588 (JP)
• SEGAWA, Eigo
Kawasaki-shi, Kanagawa, 211-8588 (JP)

(74) Representative: Hoffmann Eitle
Patent- und Rechtsanwälte PartmbB
Arabellastraße 30
81925 München (DE)

(54) **COMPUTER PROGRAM, TRAFFIC SIMULATION METHOD, AND INFORMATION PROCESSING APPARATUS**

(57) A computer searches for a plurality of travel routes along which a person moves from a departure point to a destination using one or more transportation modes among a plurality of transportation modes, the one or more transportation modes being different from each other among the plurality of travel routes, predicts a first travel route to be selected by the person from the plurality of travel routes by using a behavior model for predicting a selection behavior based on features indicating states of the plurality of transportation modes, simulates a first movement of the person along a time axis using the first travel route, and updates the features using a result of the first movement.

FIG. 1

**Description**

FIELD

The embodiments discussed herein relate to a computer program, a traffic simulation method, and an information processing apparatus.

BACKGROUND

A computer may execute a traffic simulation that simulates usage of a plurality of modes of transportation in a certain area. Some people may select a multimodal travel route for moving from a departure point to a destination by transferring two or more transportation modes. The result of the traffic simulation may be utilized for city planning such as scheduling of public transportation, improvement of roads, installation of parking lots, and change of fares of transportation.

A route search method has been proposed in which a multimodal travel route is presented to a user in consideration of real-time information such as a current traffic volume and a state of a parking lot. In addition, there has been proposed a modeling method of generating a prediction model for predicting demand at a designated stop by learning a relationship between demand for public transportation and topography.

Further, a traffic adjustment method has been proposed in which a future traffic volume of transportation is predicted from its current traffic volume, a future traffic volume in a case where a certain corrective action is performed is simulated, and then a corrective action that improves the future traffic volume is searched for. In addition, there has been proposed a server device that searches for a normal route for reaching a destination from a departure point by a private car and a special route for leaving the private car in a parking lot and transferring to public transportation on the way, and displays the normal route and the special route on a user terminal. See, for example, the following documents.

U.S. Patent Application Publication No. 2016/0334235
U.S. Patent Application Publication No. 2017/0109764
International Publication pamphlet No. WO 2002/065148
Japanese Laid-open Patent Publication No. 2023-121091

Selection of a travel route by a person may be affected by a dynamic state of transportation such as a congestion degree. Therefore, in a traffic simulation, there is room for improvement in simulation accuracy by appropriately handling the dynamic states of the transportation.

SUMMARY

In one aspect, one object of the present embodiments is to improve the accuracy of traffic simulation.

In one aspect, there is provided a computer program that causes a computer to perform a process including: searching for a plurality of travel routes along which a person moves from a departure point to a destination using one or more transportation modes among a plurality of transportation modes, the one or more transportation modes being different from each other among the plurality of travel routes; predicting a first travel route to be selected by the person from the plurality of travel routes by using a behavior model for predicting a selection behavior based on features indicating states of the plurality of transportation modes; simulating a first movement of the person along a time axis using the first travel route; and updating the features using a result of the first movement.

BRIEF DESCRIPTION OF DRAWINGS

FIG. 1 is a diagram illustrating an information processing apparatus according to a first embodiment;
FIG. 2 is a diagram illustrating an example of hardware of an information processing apparatus according to a second embodiment;
FIG. 3 is a diagram illustrating an example of travel routes from a departure point to a destination;
FIG. 4 is a diagram illustrating a first example of simulation cycles;
FIG. 5 is a diagram illustrating a second example of simulation cycles;
FIG. 6 illustrates an example of origin destination (OD) data;
FIG. 7 illustrates an example of state data related to a parking lot;
FIG. 8 illustrates an example of state data related to a station and a train;

FIG. 9 illustrates a calculation example of selection probabilities of travel routes;

FIG. 10 is a block diagram illustrating an example of functions of the information processing apparatus;

FIG. 11 is a diagram illustrating an example of components of state data;

FIG. 12 is a flowchart illustrating an example of a procedure of traffic simulation;

FIG. 13 is a flowchart illustrating an example of a procedure of OD record processing; and

FIG. 14 is a flowchart illustrating an example of a procedure of parking processing;

DESCRIPTION OF EMBODIMENTS

Hereinafter, embodiments will be described with reference to the drawings.

(a) First Embodiment

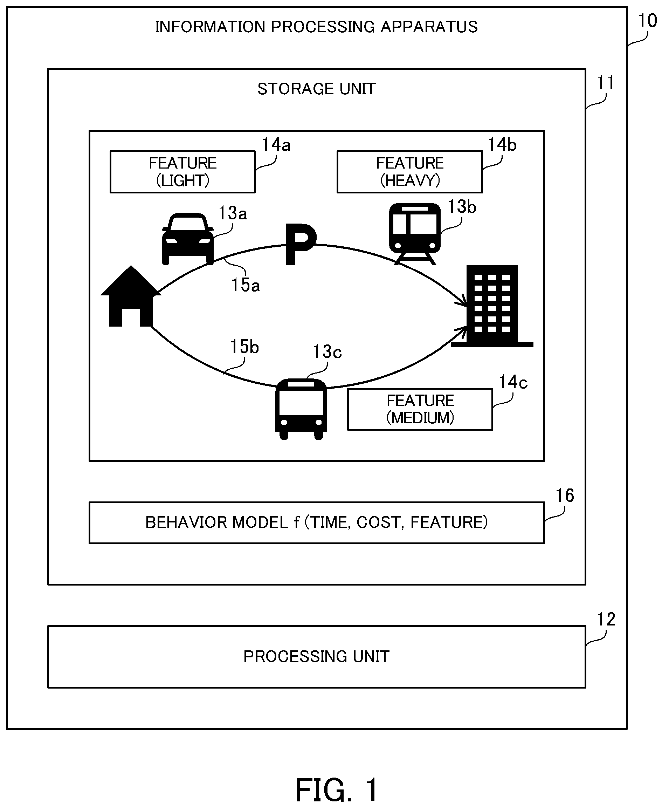

FIG. 1 is a diagram illustrating an information processing apparatus according to a first embodiment. The information processing apparatus 10 according to the first embodiment executes a traffic simulation that simulates the usage of a plurality of modes of transportation in a certain area. The information processing apparatus 10 may be a client apparatus or a server apparatus. The information processing apparatus 10 may be referred to as a computer or a traffic simulation apparatus. The traffic simulation of the first embodiment described below is a technique for improving computer functions.

The information processing apparatus 10 includes a storage unit 11 and a processing unit 12. The storage unit 11 may be a volatile semiconductor memory such as a random access memory (RAM). The storage unit 11 may be a non-volatile storage such as a hard disk drive (HDD) or a flash memory.

The processing unit 12 is, for example, a processor such as a central processing unit (CPU), a graphics processing unit (GPU), or a digital signal processor (DSP). However, the processing unit 12 may include an electronic circuit such as an application specific integrated circuit (ASIC) or a field programmable gate array (FPGA). The processor executes, for example, a program stored in a memory such as a RAM. The processor may be referred to as a processor circuitry. In addition, a set of processors may be referred to as a multiprocessor or simply a "processor". Different processors may perform different ones of a plurality of processes that will be described below.

The storage unit 11 stores features indicating states of a plurality of modes of transportation. The modes of transportation and transportation modes refer to the means of movement for a person to travel, and may be referred to as means of transportation or means of travel. Transportation modes may include walking, bicycles, private cars, buses, trains, ships and airplanes. A feature indicates a dynamic state of a transportation mode, and may include a congestion degree or a delay time.

For example, features related to walking may include a congestion degree of a pedestrian road. Features related to bicycles may include a congestion degree of a bicycle road and a congestion degree of a bicycle parking lot. Features related to private cars may include a congestion degree of a roadway and a congestion degree of a parking lot. Features related to buses may include a congestion degree of a bus and a congestion degree of a bus stop. Features related to trains may include a congestion degree of a train and a congestion degree of a station. Features related to ships may include a congestion degree of a ship and a congestion degree of a port. Features related to airplanes may include a congestion degree of an airplane and a congestion degree of an airport.

At the start of the traffic simulation, features of the plurality of modes of transportation may be initialized to initial values. As an example, the storage unit 11 stores a feature 14a of transportation mode 13a, a feature 14b of transportation mode 13b, and a feature 14c of transportation mode 13c.

The storage unit 11 also stores a behavior model 16. The behavior model 16 is a model for predicting a selection behavior in which a person selects a travel route. The behavior model 16 may be a machine learning model trained through machine learning, and may be a linear function or a non-linear function including predetermined coefficients. The behavior model 16 may calculate a selection probability of each of the plurality of travel routes. For example, the behavior model 16 calculates a selection probability that a travel route is selected from the time, cost, and feature of the travel route.

The processing unit 12 executes a traffic simulation. First, the processing unit 12 searches for a plurality of travel routes for a person to move from a departure point to a destination. The departure point and the destination may be given in advance as a traffic demand. The traffic demand may be randomly generated for the traffic simulation. The processing unit 12 may search for a plurality of travel routes for each of a plurality of people having different departure points and/or destinations.

A travel route includes one or more modes of transportation among a plurality of modes of transportation. The plurality of travel routes are different from each other in transportation modes to be used. The processing unit 12 may search for a travel route using a bus or a train by using timetable data of public transportation. The processing unit 12 may search for a travel route using a bicycle or a private car by using road map data.

The travel route may include transfers between different transportation modes and such a travel route may be referred to as a multimodal travel route. For example, a travel route may be a route in which a person departs from a departure point by a private car, parks the private car in a parking lot, and transfers to a bus or a train. In searching for possible travel routes, the processing unit 12 may determine whether transfer is possible by using features of transportation modes such as a congestion degree. As an example, the travel route 15a uses the transportation modes 13a and 13b. The travel route 15b uses the transportation mode 13c.

The processing unit 12 predicts a travel route to be selected by the aforementioned person from among a plurality of travel routes by using the features of the plurality of modes of transportation and the behavior model 16. The processing unit 12 may randomly select any travel route according to the selection probabilities calculated by the behavior model 16.

As an example, the processing unit 12 calculates the time, cost, and feature of the travel route 15a. The time of the travel route 15a may be the sum of the travel time of the transportation mode 13a and the travel time of the transportation mode 13b. The cost of the travel route 15a may be the sum of the fee of the transportation mode 13a and the fare of the transportation mode 13b. The feature of the travel route 15a may be calculated from the features 14a and 14b, or may indicate an average congestion degree of the transportation modes 13a and 13b.

The processing unit 12 may calculate the time and cost of the travel route 15a using the timetable data and the road map data. The processing unit 12 may calculate the time by further using the features 14a and 14b. The congestion degree of a road and the congestion degree of a parking lot may affect the travel time. The processing unit 12 may calculate the cost by further using the features 14a and 14b. The congestion degree of a parking lot may affect its parking fee.

The processing unit 12 inputs the time, cost, and feature of the travel route 15a to the behavior model 16 to calculate the selection probability of the travel route 15a. In addition, the processing unit 12 inputs the time, cost, and feature of the travel route 15b to the behavior model 16 to calculate the selection probability of the travel route 15b. The selection probability of a travel route including a transportation mode with a high degree of congestion may be low. The behavior model 16 may calculate the selection probability by further using a profile such as the age and gender of the aforementioned person. The profile of the person may be randomly generated along with the traffic demand for the traffic simulation. The processing unit 12 may select the travel route 15a according to the selection probabilities of the travel routes 15a and 15b.

The processing unit 12 simulates movements of people along the time axis using predicted travel routes. The processing unit 12 may calculate the location of the aforementioned person after a certain period of time using the timetable data and the road map data. The processing unit 12 may calculate the location of the person after the certain period of time by further using the feature of the transportation mode included in the predicted travel route. The processing unit 12 identifies the transportation mode used by the person within the certain period of time.

The processing unit 12 updates the features of the transportation modes included in the predicted travel route using the result of the movement. In a case where the use of a transportation mode is started within the certain period of time, the processing unit 12 updates the feature so that the congestion degree of the transportation mode increases. In a case where the use of a transportation mode ends within the certain period of time, the processing unit 12 updates the feature so that the congestion degree of the transportation mode decreases. The processing unit 12 may calculate the congestion degree of each transportation mode from the results of the movements of the plurality of people.

In the traffic simulation, the processing unit 12 may repeat a cycle including search for travel routes, selection of a travel route, and execution of the movement a plurality of times. At this time, the processing unit 12 may continue to use the feature of the transportation mode updated in a cycle in the next cycle.

Different cycles may correspond to different time periods. In this case, the state of a transportation mode at the end time of a certain period carries over to the start time of the next period. Therefore, selection of a travel route of a person in a certain period affects selection of a travel route of another person in the next period. Also, different cycles may correspond to multiple trials for the same person and the same period of movement. In this case, the state of a transportation mode predicted by one trial carries over to the next trial. Therefore, a state of a transportation mode may converge through a plurality of cycles.

The processing unit 12 outputs a result of the traffic simulation. The result of the traffic simulation may include a movement result of one or more persons along a time axis, and may include a temporal change in the feature of each transportation mode. Further, the result of the traffic simulation may include an index value indicating efficiency of movement of a person, such as a carbon dioxide emission. The processing unit 12 may store the result of the traffic simulation in a non-volatile storage, display the result on a display device, or transmit the result to another information processing apparatus.

As described above, the information processing apparatus 10 according to the first embodiment searches for a plurality of travel routes along which a person moves from a departure point to a destination using one or more modes of transportation among a plurality of modes of transportation. In this connection, the one or more modes of transportation are different from each other among the plurality of travel routes. The information processing apparatus 10 predicts a first travel route to be selected by a person from among the plurality of travel routes by using a behavior model 16 that predicts a selection behavior on the basis of features indicating the states of the plurality of modes of transportation. The information processing apparatus 10 simulates a first movement of the person along the time axis using the first travel route. The information processing apparatus 10 updates the features using the result of the first movement.

Accordingly, the information processing apparatus 10 is able to execute a multimodal traffic simulation that allows a person to move from a departure point to a destination while changing transportation modes. Therefore, the information processing apparatus 10 is able to simulate the usage of a plurality of modes of transportation in a certain region, and provide information useful for city planning. In addition, the information processing apparatus 10 may reflect the interdependency between selection of travel routes of people and the dynamic states of transportation modes in the traffic simulation, which improves the accuracy of the traffic simulation.

(b) Second Embodiment

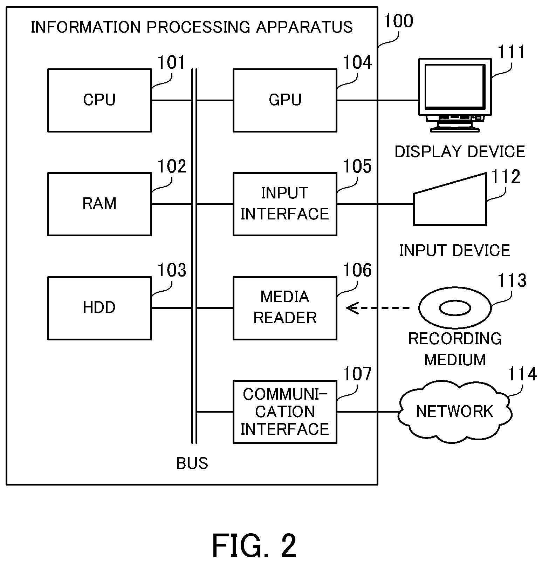

FIG. 2 is a diagram illustrating an example of hardware of an information processing apparatus according to a second embodiment. The information processing apparatus 100 according to the second embodiment executes a multimodal traffic simulation. The information processing apparatus 100 may be a client apparatus or a server apparatus. The information processing apparatus 100 corresponds to the information processing apparatus 10 of the first embodiment. The traffic simulation of the second embodiment described below is a technique for improving computer functions.

The information processing apparatus 100 includes a CPU 101, a RAM 102, an HDD 103, a GPU 104, an input interface 105, a media reader 106, and a communication interface 107, which are connected to a bus. The CPU 101 corresponds to the processing unit 12 of the first embodiment. The RAM 102 or the HDD 103 corresponds to the storage unit 11 of the first embodiment.

The CPU 101 is a processor that executes instructions of a program. The CPU 101 loads a program and data stored in the HDD 103 into the RAM 102 to executes the program. The information processing apparatus 100 may include a plurality of processors.

The RAM 102 is a volatile semiconductor memory that temporarily stores programs and data. The program is executed by the CPU 101, and data is used for computation by the CPU 101. The information processing apparatus 100 may include a volatile memory of a type other than the RAM.

The HDD 103 is a non-volatile storage that stores software programs and data. The software includes an operating system (OS), middleware, and application software. The information processing apparatus 100 may include another type of non-volatile storage such as a solid state drive (SSD) .

The GPU 104 performs image processing in cooperation with the CPU 101, and displays an image on a display device 111 connected to the information processing apparatus 100. The display device 111 is, for example, a cathode ray tube (CRT) display, a liquid crystal display, an organic electro luminescence (EL) display, or a projector.

The GPU 104 may be used as a general-purpose computing on graphics processing unit (GPGPU). The GPU 104 may execute a program in accordance with an instruction from the CPU 101. The information processing apparatus 100 may include a volatile semiconductor memory other than the RAM 102 as a GPU memory.

The input interface 105 receives an input signal from an input device 112 connected to the information processing apparatus 100. The input device 112 is, for example, a mouse, a touch panel, or a keyboard. A plurality of input devices may be connected to the information processing apparatus 100.

The media reader 106 is a reading device that reads a program and data from a recording medium 113. The recording medium 113 is, for example, a magnetic disk, an optical disk, or a semiconductor memory. The magnetic disk includes a flexible disk (FD) and an HDD. The optical disc includes a compact disc (CD) and a digital versatile disc (DVD). The media reader 106 copies the program and data read from the recording medium 113 to the RAM 102 or the HDD 103.

The read program may be executed by the CPU 101. The recording medium 113 may be a portable recording medium. The recording medium 113 may be used for distribution of programs and data. The recording medium 113 and the HDD 103 may be referred to as a computer-readable recording medium.

The communication interface 107 communicates with other information processing apparatuses via the network 114. The communication interface 107 may be a wired communication interface connected to a router or a switch by a wired cable. In addition, the communication interface 107 may be a wireless communication interface connected to a base station or an access point via a wireless link.

Next, the multimodal traffic simulation will be described. The information processing apparatus 100 executes a human behavior simulation in which a plurality of agents representing a plurality of people are moved in accordance with a certain rule in a virtual space that reproduces a real space of a target region with high accuracy. This virtual space may be referred to as a digital twin. The virtual space includes virtual transportation modes reproduced from data of actual transportation modes such as timetable data and road map data.

The information processing apparatus 100 randomly generates a plurality of agents representing a plurality of people with reference to data of residents in a target area. Each agent has a traffic demand and profile. The information processing apparatus 100 moves the plurality of agents in the virtual space according to their traffic demands and the profiles. Transportation modes available to the agent include walking, private cars, bicycles, buses, trains, ships, and airplanes. The information processing apparatus 100 outputs a movement result of each agent, a dynamic state of each transportation, and other evaluation index values. The evaluation index value is an index value indicating efficiency of the design of transportation in the target area, such as a total carbon dioxide emission of a plurality of transportation modes.

Note that the information processing apparatus 100 may execute the human behavior simulation on a digital twin in which the real world and the virtual space are time-synchronized. More specifically, the information processing apparatus 100 generates a digital twin in which the states of a plurality of transportation modes in the real world are reproduced in a virtual space and the real world and the virtual space are time-synchronized. Then, the information processing apparatus 100 simulates behaviors of a plurality of people by moving each of a plurality of agents corresponding to each of the plurality of people present in the real world in the generated digital twin. For example, the digital twin reproduces the actual states of a plurality of transportation modes in the virtual space on the basis of sensing data of sensors installed in the real world and current operation data of the transportation modes. Then, the information processing apparatus 100 arranges the plurality of agents representing a plurality of people on the digital twin in which the states of the plurality of transportation modes are reproduced, and executes a human behavior simulation to move the plurality of agents arranged on the digital twin in accordance with a certain rule.

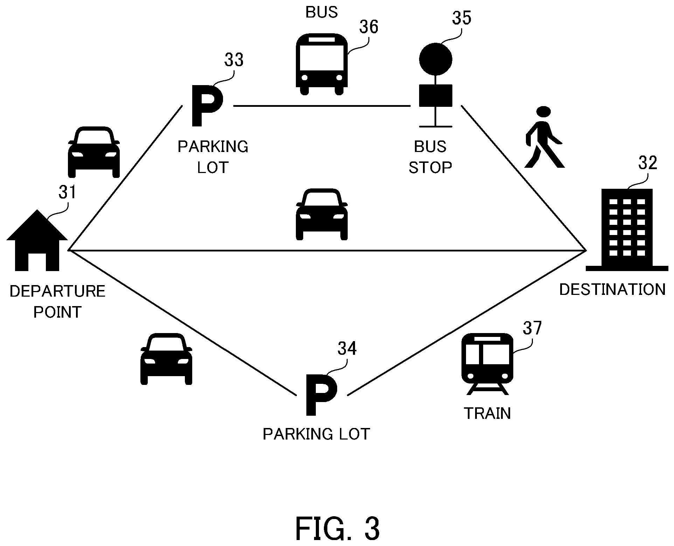

FIG. 3 is a diagram illustrating an example of travel routes from a departure point to a destination. In the multimodal traffic simulation, an agent has a traffic demand to travel from a departure point 31 to a destination 32. There are a plurality of travel routes between the departure point 31 and the destination 32.

According to the first travel route, the agent moves from the departure point 31 to a parking lot 33 by private car and parks the private car in the parking lot 33. The agent transfers to a bus 36 and travels by the bus 36 to a bus stop 35. The agent walks from the bus stop 35 to the destination 32. According to the second travel route, the agent travels from the departure point 31 to the destination 32 by private car. According to the third travel route, the agent travels from the departure point 31 to a parking lot 34 by private car and parks the private car in the parking lot 34. The agent transfers to a train 37 and moves to the destination 32 by the train 37.

In this way, the information processing apparatus 100 searches for a plurality of travel routes from a departure point to a destination for travel for each of a plurality of people. The information processing apparatus 100 calculates the utility of each travel route for individual people using a utility function. The utility is affected by the time and cost of the travel route, the dynamic state of the transportation included in the travel route, and the profile of the person. The dynamic state includes a congestion degree. The information processing apparatus 100 calculates a selection probability of each travel route from the utility, and randomly selects any one travel route from the plurality of travel routes according to the selection probabilities.

In the route search, the information processing apparatus 100 may use public transportation data such as general transit feed specification (GTFS). The public transportation data includes locations of stations, operation schedules of trains, fares between stations, locations of bus stops, operation schedules of buses, and fares between bus stops. The information processing apparatus 100 may use road map data such as open street map (OSM). The road map data indicates roads, locations of parking lots, and locations of bicycle parking lots. The information processing apparatus 100 may use a route search program such as an open trip planner (OTP).

The multimodal traffic simulation includes a plurality of cycles. Different cycles may correspond to different time periods. Further, different cycles may correspond to different trials for the same simulation target period. In each cycle, the information processing apparatus 100 feeds back movement results of a plurality of people and updates state data indicating dynamic states of transportation modes. Transportation modes that many people use have a high degree of congestion. The information processing apparatus 100 continues to use the state data updated in a certain cycle in the next cycle.

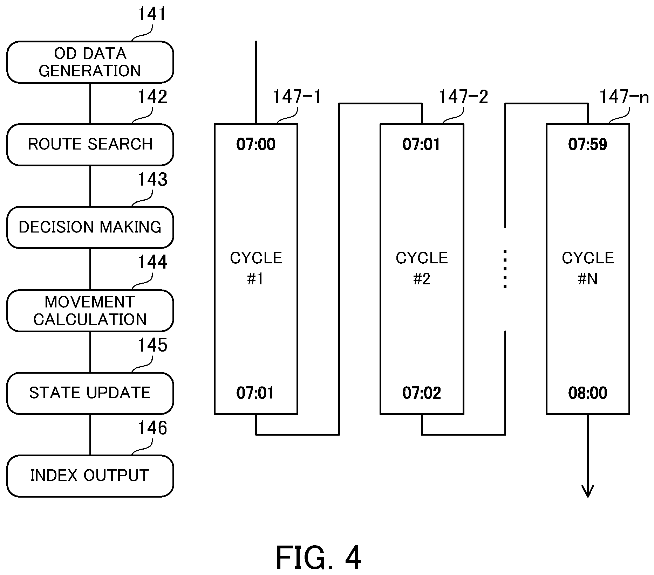

FIG. 4 is a diagram illustrating a first example of simulation cycles. The multimodal traffic simulation includes origin destination (OD) data generation 141, route search 142, decision making 143, movement calculation 144, state update 145, and index output 146.

The OD data generation 141 generates OD data from data of residents in the target area. The OD data includes a plurality of OD records corresponding to a plurality of people. The resident data may be a result of questionnaires conducted in the target region. The OD record includes a departure point, a destination, and a departure time. The OD record also includes a profile such as age and gender.

For example, the OD data generation 141 randomly selects a departure point from the target area according to the distribution of addresses of the residents in the target area. In addition, the OD data generation 141 randomly selects a destination from the target area according to the distribution of work places of the residents. In addition, the OD data generation 141 randomly selects a departure time according to the distribution of commuting hours of the residents. In addition, the OD data generation 141 randomly selects age and gender of each OD record according to the age distribution and the gender distribution of the residents.

The route search 142 searches for a plurality of travel routes that starts from the departure point at the departure time and reach the destination for each OD record. At this time, the route search 142 uses public transportation data, road map data, and state data. For example, the route search 142 calculates travel time by walking from the length of the road indicated by the road map data. In addition, the route search 142 calculates travel time by bicycle from the length of the road and the congestion degree of the bicycle parking lot indicated by the state data.

The route search 142 calculates travel time by private car from the length of the road, the congestion degree of the road indicated by the state data, and the congestion degree of the parking lot indicated by the state data. In addition, the route search 142 calculates travel time by bus from the operation schedule of the bus indicated by the public transportation data and the congestion degree of the road. The route search 142 calculates travel time by train from the operation schedule of the train indicated by the public transportation data.

The decision making 143 calculates the utility of each of the plurality of travel routes using the utility function for each OD record, and calculates the selection probability of each travel route from the relative relationship of the utilities of the plurality of travel routes. The decision making 143 selects any one travel route according to the selection probabilities for each OD record. The utility function calculates the utility from the time, cost, and congestion degree of the travel route. The decision making 143 may change the weight of each of the time, cost, and congestion degree according to the profile such as age and gender included in the OD record.

Decision making 143 identifies time of the travel route from the result of the route search 142. In addition, the decision making 143 calculates the total cost of the transportation modes included in the travel route as the cost of the travel route. For example, the cost of walking and bicycles is zero. The cost of the private car is the sum of the fuel cost according to the length of the road and the parking fee of the parking lot. The parking fee of the parking lot may vary depending on the congestion degree of the parking lot. The cost of the bus is a bus fare according to the boarding section. The cost of the train is a train fare corresponding to the boarding section.

Further, the decision making 143 identifies the congestion degree of the travel route from the congestion degree of one or more transportation modes included in the travel route. The congestion degree is inversely proportional to the comfort degree. The congestion degree of the travel route is, for example, a maximum value or an average value of the congestion degrees of the one or more transportation modes. For example, the congestion degree related to bicycles includes a congestion degree of a bicycle parking lot. The congestion degree related to private cars includes a congestion degree of a parking lot. The congestion degree related to buses includes a congestion degree of the vehicle itself and a congestion degree of a bus stop. The congestion degree related to trains includes a congestion degree of the train car itself and the congestion degree of a station.

The movement calculation 144 moves a person in the virtual space along the selected travel route for each OD record. Thus, the location of the person at each time point is determined. The state update 145 updates the state data using the movement results of the plurality of people corresponding to the plurality of OD records. For example, the state update 145 calculates the congestion degree of a bicycle parking lot from the locations of bicycles after a certain time.

In the state update 145, the congestion degree of a road and the congestion degree of a parking lot are calculated from the locations of private cars after a certain period of time. In addition, the state update 145 calculates the congestion degree of a bus vehicles and the congestion degree of a bus stop from the locations of people after a certain period of time. Further, the state update 145 calculates the congestion degree of a train vehicle and the congestion degree of a station from the locations of people after a certain time.

The index output 146 calculates an evaluation index value such as a carbon dioxide emission from the usage of the transportation modes in the entire target period. For example, the carbon dioxide emission of walking and bicycles is zero. The index output 146 calculates the carbon dioxide emission of private cars from the total travel distance of the private cars of the plurality of people. The index output 146 calculates the carbon dioxide emission of buses from the total travel distance of the buses in the target period indicated by the public transportation data. The index output 146 calculates the carbon dioxide emission of trains from the total travel distance of the trains in the target period indicated by the public transportation data.

In the multimodal traffic simulation, the information processing apparatus 100 first executes OD data generation 141. Next, the information processing apparatus 100 repeats a cycle including the route search 142, the decision making 143, the movement calculation 144, and the state update 145 n times. Here, the information processing apparatus 100 divides the entire target period into n periods. The time width per cycle is, for example, 1 second, 10 seconds, 1 minute, or the like.

As an example, the information processing apparatus 100 sequentially executes the cycles 147-1 to 147-n. The cycle 147-1 simulates the movement of people from 07:00 to 07:01. Prior to the cycle 147-1, the information processing apparatus 100 initializes state data indicating dynamic states of transportation modes. The information processing apparatus 100 executes the route search 142 and the decision making 143 in the cycle 147-1 using the initialized state data. The state update 145 of the cycle 147-1 calculates the dynamic states of the transportation modes at 07:01.

The cycle 147-2 simulates the movement of people from 07:01 to07:02. The information processing apparatus 100 executes the route search 142 and the decision making 143 in the cycle 147-2 by using the state data updated by the state update 145 in the cycle 147-1. The state update 145 of the cycle 147-2 calculates the dynamic state of the transportation modes at 07:02.

The cycle 147-n simulates the movement of people from 07:59 to 08:00. The information processing apparatus 100 executes the route search 142 and the decision making 143 in the cycle 147-n using the state data updated by the state update 145 in the previous cycle. The state update 145 of the cycle 147-n calculates the dynamic state of the transportation modes at 08:00. Finally, the information processing apparatus 100 executes an index output 146.

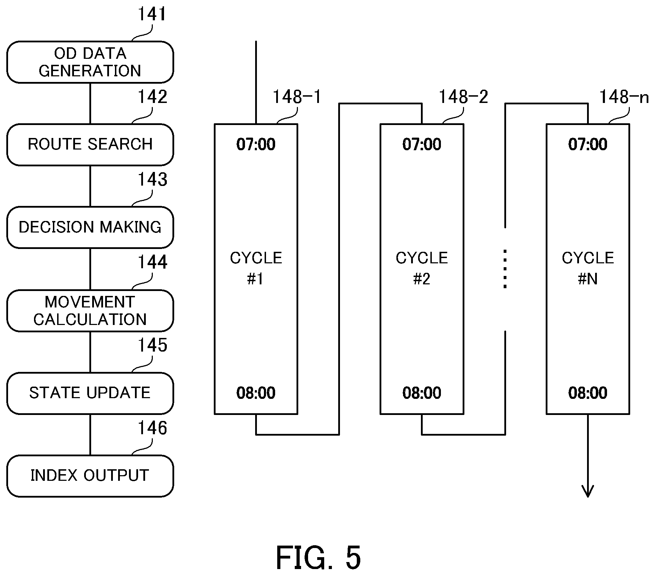

FIG. 5 is a diagram illustrating a second example of simulation cycles. Here, the information processing apparatus 100 performs the movement simulation n times for the same OD data and the same target period. Since the decision making 143 uses random numbers, the selection result of the travel route differs among the n trials. Further, the information processing apparatus 100 continues to use the state data updated in a certain trial in the next trial. Accordingly, the information processing apparatus 100 levels out the impact of the random numbers such that the dynamic state of the transportation modes converges to an appropriate state.

As an example, the information processing apparatus 100 sequentially executes the cycles 148-1 to 148-n. The cycle 148-1 simulates the movement of people from 07:00 to 08:00. Prior to the cycle 148-1, the information processing apparatus 100 initializes state data indicating dynamic states of transportation modes. The information processing apparatus 100 executes the route search 142 and the decision making 143 in the cycle 148-1 using the initialized state data. The state update 145 of cycle 148-1 updates the dynamic states of the transportation modes between 07:00 and 08:00.

The cycle 148-2 again simulates the movement of the people from 07:00 to 08:00. The information processing apparatus 100 executes the route search 142 and the decision making 143 in the cycle 148-2 using the state data updated by the state update 145 in the cycle 148-1. The state update 145 of cycle 148-2 updates the dynamic states of the transportation modes between07:00 and 08:00.

The cycle 148-n again simulates the movement of the people from07:00 to 08:00. The information processing apparatus 100 executes the route search 142 and the decision making 143 in the cycle 148-n using the state data updated by the state update 145 in the previous cycle. The state update 145 of cycle 148-n updates the dynamic states of the transportation modes between 07:00 and 08:00.

The index output 146 may calculate an evaluation index value such as a carbon dioxide emission using the movement result of the last cycle 148-n. The index output 146 may calculate an average evaluation index value from the movement results of the cycles 148-1 to 148-n. The index output 146 may output the dynamic states of the transportation modes in the last cycle 148-n, or may output the average dynamic states of the cycles 148-1 to 148-n. Further, the information processing apparatus 100 may execute a combination of FIGS. 4 and 5.

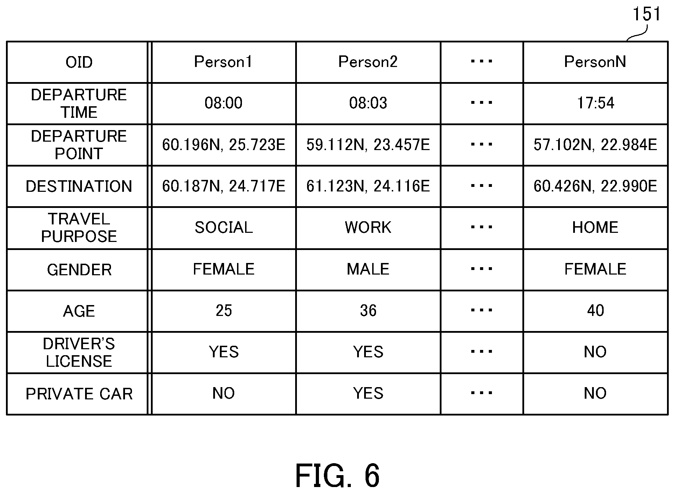

FIG. 6 is a diagram illustrating an example of OD data. The table 151 stores OD data including a plurality of OD records. The OD record includes an OID, departure time, departure point, destination, travel purpose, gender, age, possession or not of a driver's license, and possession or not of a private car.

The OID identifies the OD record. The departure point and the destination are represented using latitude and longitude. The departure time, the departure point, and the destination indicate traffic demands. The purpose of travel is, for example, going to work or coming home. The purpose of travel, gender, and age are input into the utility function and affect the travel route selection behavior of the person. For example, the information processing apparatus 100 calculates weights for the time, fee, and congestion degree from a combination of the travel purpose, gender, and age according to a rule determined in advance. In addition, for example, in a case where a combination of the travel purpose, gender, and age satisfies a specific condition, the information processing apparatus 100 sets the selection probability of the travel routes whose congestion degree exceeds a threshold value to zero.

The possession or not of a driver's license and the possession or not of a private car are used in the search for a travel route from the departure point to the destination. For an OD record having "YES" in the item of driver's license and "YES" in the item of private car, the information processing apparatus 100 also searches for a travel route including the private car as a transportation mode. On the other hand, for an OD record that has "NO" in the item of driver's license or has "NO" in the item of private car, the information processing apparatus 100 does not search for a travel route including a private car as a transportation mode.

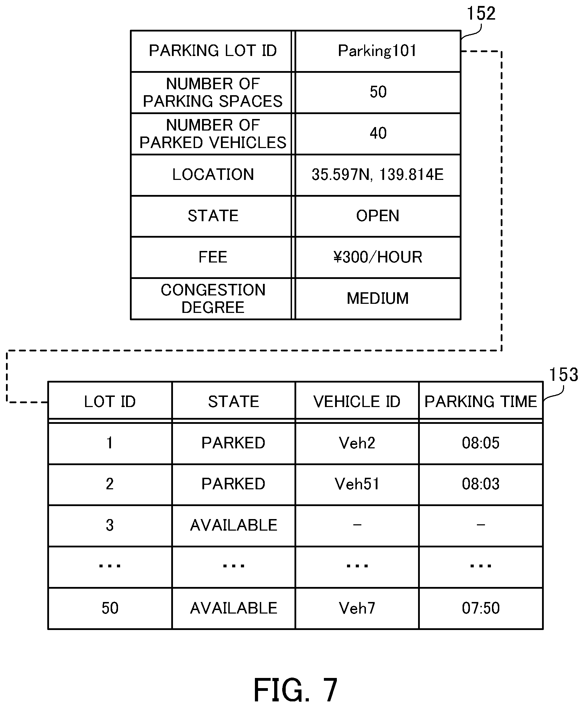

FIG. 7 is a diagram illustrating an example of state data related to a parking lot. The table 152 stores state data indicating a dynamic state of one parking lot. The table 152 includes a parking lot ID, the number of parking spaces, the number of parked vehicles, location, state, fee, and congestion degree. The parking lot ID identifies the parking lot. The number of parking spaces is the number of parking spaces (or parking lots) that the parking lot has. The number of parked vehicles is the number of parking spaces in use. The location of the parking lot is represented using latitude and longitude.

The state is open or closed. The fee is a parking fee per hour, which may vary depending on the degree of congestion. The congestion degree is light, medium, or heavy. For example, when the ratio of the number of parked vehicles to the number of parking spaces is less than a first threshold, the information processing apparatus 100 determines that the congestion degree is light. When the ratio is between the first threshold and the second threshold, inclusive, the information processing apparatus 100 determines that the congestion degree is medium. When the ratio exceeds the second threshold, the information processing apparatus 100 determines that the congestion degree is heavy.

The table 153 is associated with the table 152. The table 153 stores state data indicating details of the usage of the parking lot indicated by the table 152. The table 153 stores a plurality of records each including a lot ID, state, vehicle ID, and parking time. The lot ID identifies the parking space. The state is parked or available. The vehicle ID identifies the vehicle parked in the parking space. The parking time is an entry time.

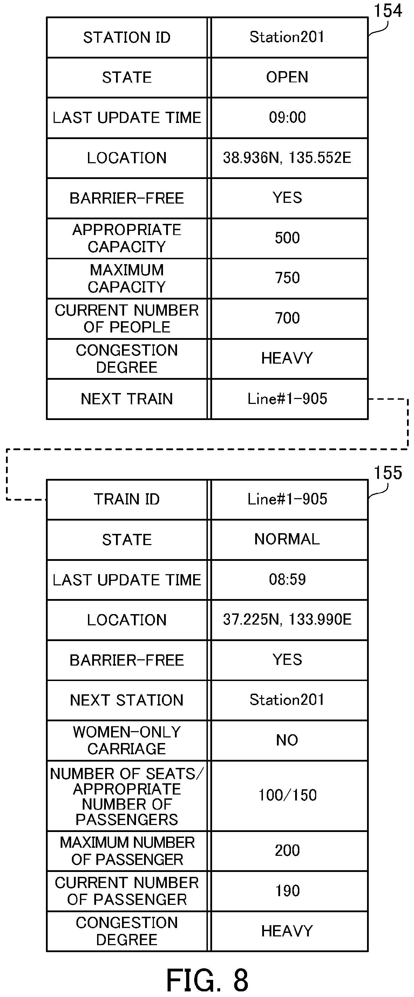

FIG. 8 is a diagram illustrating an example of state data related to a station and a train. The table 154 stores state data indicating a dynamic state of one station. The table 154 includes a station ID, state, last update time, location, presence or absence of barrier-free, appropriate capacity, maximum capacity, current number of people, congestion degree, and next train. The station ID identifies the station.

The state is open or closed. The last update time is a simulation time at which the current number of people, the congestion degree, and the next train are updated. The location of the station is represented using latitude and longitude. The presence or absence of barrier-free indicates whether or not the station has barrier-free facilities. The appropriate capacity is the number of people the station assumed to accommodate in design. The maximum capacity is an upper limit of the allowable number of people staying in the station. The current number of people is the current number of people staying in the station.

The congestion degree is light, medium, or heavy. For example, the information processing apparatus 100 determines the congestion degree from a ratio of the current number of people to the appropriate capacity or a ratio of the current number of people to the maximum capacity. The next train identifies the train that is scheduled to arrive at the station next. If a plurality of lines runs through the station, there would be the next train for each of the plurality of lines.

The table 155 is associated with the table 154. The table 155 stores state data indicating a dynamic state of one train. The table 155 includes a train ID, state, last update time, location, the presence or absence of barrier free, next station, presence or absence of a woman-only carriage, the number of seats and the appropriate number of passengers, the maximum number of passengers, the current number of passengers, and congestion degree. The train ID identifies the train.

The state is normal, delayed, or the like. The last update time is a simulation time at which the next station, the current number of passengers, and the congestion degree are updated. The location of the train is represented using latitude and longitude. The presence or absence of barrier-free indicates whether or not the train has barrier-free facilities. The next station identifies the station at which the train is scheduled to stop next.

The appropriate number of passengers is the number of passengers of the train assumed in design. The appropriate number of passengers is the sum of the number of seats and the number of standing passengers assumed in design. The maximum number of passengers is an upper limit of the number of passengers that the train is allowed to carry. The current number of passengers is the current number of passengers on the train. The congestion degree is light, medium, or heavy. For example, the information processing apparatus 100 determines the congestion degree from the ratio of the current number of passengers to the appropriate number of passengers or the ratio of the current number of passengers to the maximum number of passengers.

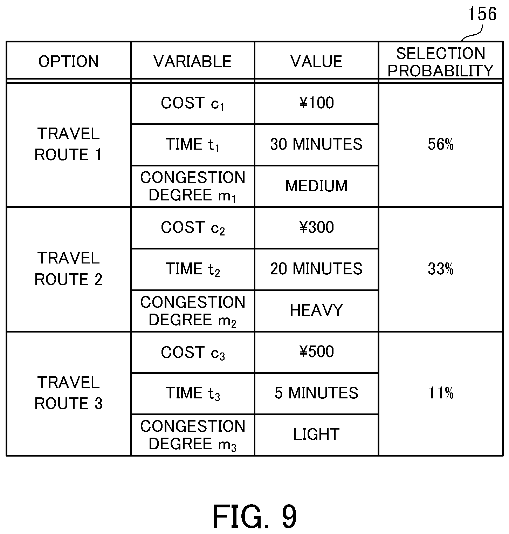

FIG. 9 is a diagram illustrating a calculation example of selection probabilities of travel routes. The table 156 associates an option, variable, value, and selection probability. The information processing apparatus 100 searches for a plurality of travel routes as options for each of the plurality of OD records. In the example of the table 156, the information processing apparatus 100 has found three travel routes for a certain OD record.

The information processing apparatus 100 calculates the utility $V_k$ of the travel route k using a utility function such as Equation (1). In Equation (1), for ease of explanation, the utility function is a linear function. In Equation (1), $c_k$ is the cost of the travel route k, $t_k$ is the time of the travel route k, and $m_k$ is the congestion degree of the travel route k. $\beta_c$ is the weight of the cost, $\beta_t$ is the weight of the time, and $\beta_m$ is the weight of the congestion degree.

$$V_k = \beta_c c_k + \beta_t t_k + \beta_m m_k \tag{1}$$

The cost $c_k$, the time $t_k$, and the congestion degree $m_k$ are variables for calculating the utility $V_k$. A numerical value representing the congestion degree is substituted for $m_k$. The higher the congestion degree is, the larger the value of $m_k$ is. The utility function may further include other variables. The weights $\beta_c$, $\beta_t$, and $\beta_m$ may be determined in advance by machine learning or may be designated by the user. The information processing apparatus 100 may select the weights $\beta_c$, $\beta_t$, and $\beta_m$ in accordance with the profile included in the OD record.

The information processing apparatus 100 calculates a plurality of utilities corresponding to the plurality of travel routes using the utility function. Then, the information processing apparatus 100 calculates the selection probability $P_k$ of the travel route k from the plurality of utilities using the logit function indicated in Equation (2). The selection probability $P_k$ is a numerical value between 0 and **1,** inclusive. The sum of the selection probabilities of all the travel routes is 1.

$$P_k = \frac{\exp(V_k)}{\sum_{k'} \exp(V_{k'})} \tag{2}$$

In the example of the table 156, the information processing apparatus 100 calculates the utility $V_1$ of the travel

route 1 from the cost $c_1$, the time $t_1$, and the congestion degree $m_1$ of the travel route 1. In addition, the information processing apparatus 100 calculates the utility $V_2$ of the travel route 2 from the cost $c_2$, the time $t_2$, and the congestion degree $m_2$ of the travel route 2. In addition, the information processing apparatus 100 calculates the utility $V_3$ of the travel route 3 from the cost $c_3$, the time $t_3$, and the congestion degree $m_3$ of the travel route 3. The information processing apparatus 100 calculates the selection probabilities $P_1$, $P_2$, and $P_3$ of the travel routes 1, 2, and 3 from the utilities $V_1$, $V_2$, and $V_3$.

In the example of the table 156, the selection probability $P_1$ is 56%, the selection probability $P_2$ is 33%, and the selection probability $P_3$ is 11%. Therefore, the information processing apparatus 100 selects the travel route 1 with a probability of 56%, selects the travel route 2 with a probability of 33%, and selects the travel route 3 with a probability of 11% by using random numbers. Next, functions and processing procedures of the information processing apparatus 100 will be described.

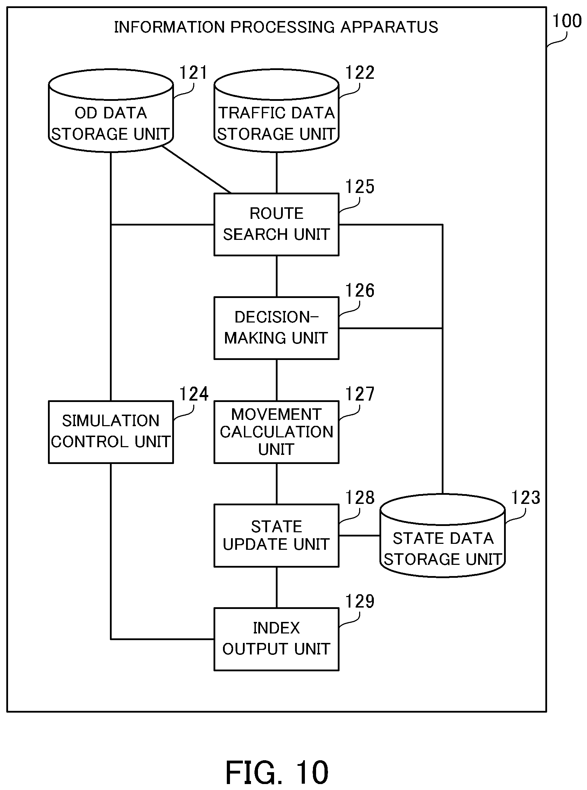

FIG. 10 is a block diagram illustrating an example of functions of the information processing apparatus. The information processing apparatus 100 includes an OD data storage unit 121, a traffic data storage unit 122, and a state data storage unit 123. These storage units are implemented using, for example, the RAM 102 or the HDD 103. In addition, the information processing apparatus 100 includes a simulation control unit 124, a route search unit 125, a decision-making unit 126, a movement calculation unit 127, a state update unit 128, and an index output unit 129. These processing units are implemented using, for example, the CPU 101 and a program.

The OD data storage unit 121 stores OD data. The OD data includes a plurality of OD records representing a plurality of people. The traffic data storage unit 122 stores traffic data indicating a static design of transportation. The traffic data includes public transportation data and road map data. The public transportation data indicates locations of bus stops, operation schedule of buses, fares between bus stops, locations of stations, operation schedule of trains, and fares between stations. The road map data indicates roads, locations of bicycle parking lots, and locations of parking lots.

The state data storage unit 123 stores state data indicating a dynamic state of transportation. The state data includes usage of roads, usage of parking lots, usage of bicycle parking lots, usage of stations, usage of trains, usage of bus stops, and usage of buses.

The simulation control unit 124 controls the multimodal traffic simulation. The simulation control unit 124 displays a user interface on the display device 111 and receives a simulation condition from the user. The simulation condition includes a target region and a target period. The simulation control unit 124 generates OD data suitable for the target region and stores the OD data in the OD data storage unit 121. The number of OD records included in the OD data, that is, the number of people to be moved may be designated by the user.

The simulation control unit 124 displays the simulation result on the display device 111. The simulation result may indicate movement of a plurality of people along the time axis. In addition, the simulation result may indicate a temporal change in a dynamic state of transportation. In addition, the simulation result may include an evaluation index value such as a carbon dioxide emission.

The route search unit 125 searches for a plurality of travel routes from the departure point to the destination for each of the plurality of OD records included in the OD data stored in the OD data storage unit 121. The route search unit 125 uses the traffic data stored in the traffic data storage unit 122 and the state data stored in the state data storage unit 123.

The decision-making unit 126 selects, for each of the plurality of OD records, any one of the plurality of travel routes retrieved by the route search unit 125 using the utility function created in advance. Here, the decision-making unit 126 inputs the congestion degree indicated by the state data to the utility function in addition to the cost and the time of the travel route, and calculates the utility of the travel route. The decision-making unit 126 calculates the selection probability of each travel route from the utilities of the plurality of travel routes. The decision-making unit 126 stochastically selects any one travel route according to the selection probabilities.

The movement calculation unit 127 moves the agent in the virtual space according to the travel route selected by the decision-making unit 126 for each of the plurality of OD records. For example, the movement calculation unit 127 calculates the location of each of the plurality of people at each time point while advancing the time by a certain period of time (for example, one second). The state update unit 128 counts the number of users of each transportation mode from the movement result of the movement calculation unit 127 to determine the dynamic states. Accordingly, the state update unit 128 updates the state data stored in the state data storage unit 123.

The index output unit 129 calculates an evaluation index value such as a carbon dioxide emission from the movement result of the movement calculation unit 127. The index output unit 129 notifies the simulation control unit 124 of the calculated evaluation index value. The information processing apparatus 100 may store the simulation result in the HDD 103 or may transmit the simulation result to another information processing apparatus.

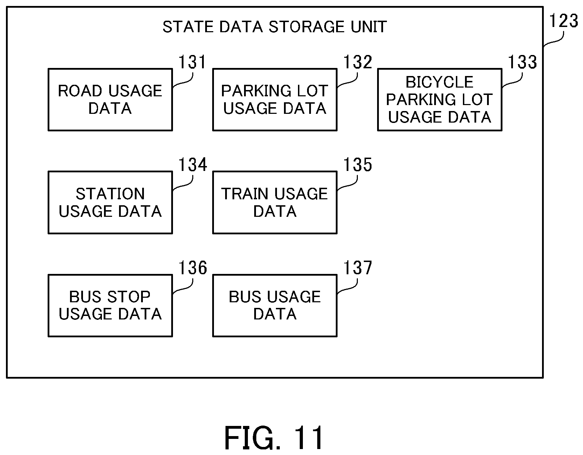

FIG. 11 is a diagram illustrating an example of components of state data. The state data stored in the state data storage unit 123 includes road usage data 131, parking lot usage data 132, bicycle parking lot usage data 133, station usage data 134, train usage data 135, bus stop usage data 136, and bus usage data 137.

The road usage data 131 includes the number of private cars for each road section. The parking lot usage data 132 includes the number of private cars for each parking lot. The bicycle parking lot usage data 133 includes the number of bicycles for each bicycle parking lot. The station usage data 134 includes the number of users for each station. Train usage data 135 includes the number of passengers for each train. The bus stop usage data 136 includes the number of users for each bus stop. The bus usage data 137 includes the number of passengers for each bus.

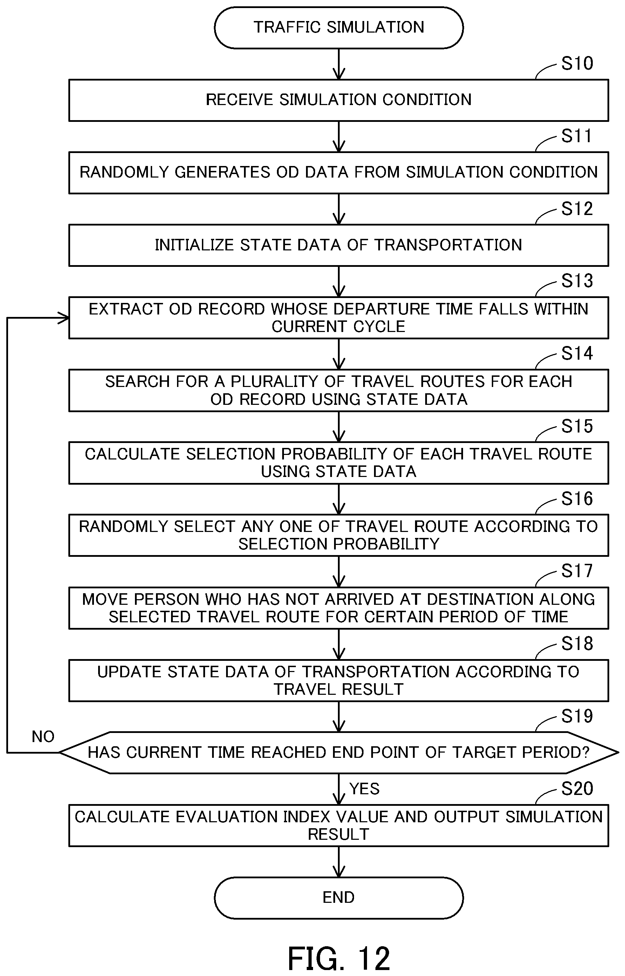

FIG. 12 is a flowchart illustrating an example of a procedure of traffic simulation. In the following description, as illustrated in FIG. 4, it is assumed that the time in the virtual space progresses by repeating the cycle. In step S10, the simulation control unit 124 receives simulation conditions such as a target region and a target period from the user. In step S11, the simulation control unit 124 randomly generates OD data indicating a plurality of people moving in the target area from the simulation conditions.

In step S12, the simulation control unit 124 initializes state data indicating dynamic states of transportation modes. The state data in an initial state may indicate that the congestion degrees of all transportation modes are low. In step S13, the route search unit 125 identifies the start time and the end time of the current cycle. The route search unit 125 extracts OD records whose departure time falls within the time period of the current cycle from the OD data generated in step S11.

In step S14, the route search unit 125 searches for a plurality of travel routes that start from the departure point and reach the destination for each OD record extracted in step S13. At this time, the route search unit 125 uses the latest state data in addition to the traffic data indicating the static design of the transportation modes.

In step S15, the decision-making unit 126 calculates the utility of each of the plurality of travel routes found in step S14 for each OD record. At this time, the decision-making unit 126 uses the profile and the latest state data included in the OD record. The decision-making unit 126 inputs the cost, time, and congestion degree of the travel route to the utility function. The decision-making unit 126 relativizes the utilities of the plurality of travel routes and calculates the selection probability of each of the plurality of travel routes.

In step S16, the decision-making unit 126 randomly selects any one of the travel routes according to the selection probabilities for each OD record. In step S17, the movement calculation unit 127 identifies people who have not arrived at their destinations. The people identified here include people who have departed in or before the previous cycle in addition to people who depart in the current cycle. The movement calculation unit 127 moves the people who have not arrived at their destinations along the selected travel routes for a certain period of time.

In step S18, the state update unit 128 calculates the congestion degree of each transportation mode according to the movement result of step S17, and updates the state data. In step S19, the simulation control unit 124 determines whether the current time in the virtual space has reached the end point of the target period. When the current time has reached the end point of the target period, the process proceeds to step S20. When the current time has not reached the end point of the target period, the simulation control unit 124 advances the time by a certain amount. Then, the process returns to step S13.

In step S20, the index output unit 129 calculates an evaluation index value by aggregating the movement results of step S17. The simulation control unit 124 outputs a simulation result. The simulation result indicates the movement of a plurality of people along the time axis, the temporal change of the congestion degree of each of a plurality of transportation modes, and the evaluation index value.

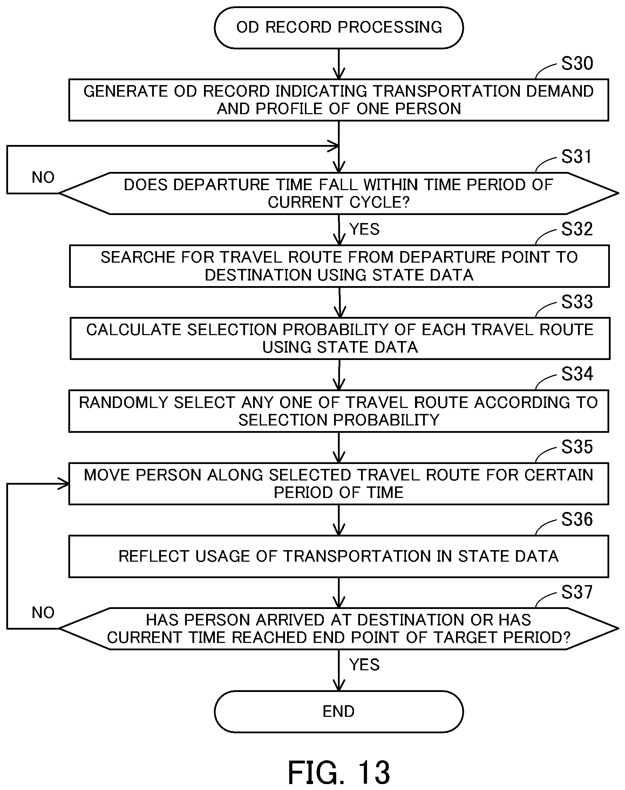

FIG. 13 is a flowchart illustrating an example of a procedure of OD record processing. Here, the traffic simulation will be described focusing on one OD record. In step S30, the simulation control unit 124 generates an OD record indicating the traffic demand and profile of one person. In step S31, the route search unit 125 determines whether the departure time of the OD record falls within the time period of the current cycle. When the departure time falls within the time period of the current cycle, the process proceeds to step S32. When the departure time does not fall within the time period of the current cycle, the process repeats step S31 and wait for the cycle to which the departure time belongs.

In step S32, the route search unit 125 searches for a plurality of travel routes that start from the departure point and reach the destination by using the latest state data. In step S33, the decision-making unit 126 calculates the utility of each travel route using the latest state data, and calculates the selection probability using the utility. In step S34, the decision-making unit 126 randomly selects any one of the plurality of travel routes according to the selection probabilities.

In step S35, the movement calculation unit 127 moves the person indicated by the OD record along the selected travel route for a certain period of time. In step S36, the state update unit 128 reflects the usage of the transportation modes simulated in the current cycle in the state data. In step S37, the simulation control unit 124 determines whether the person has arrived at the destination or the current time has reached the end point of the target period. When the condition is satisfied, the processing of the OD record ends. When the condition is not satisfied, the process returns to step S35.

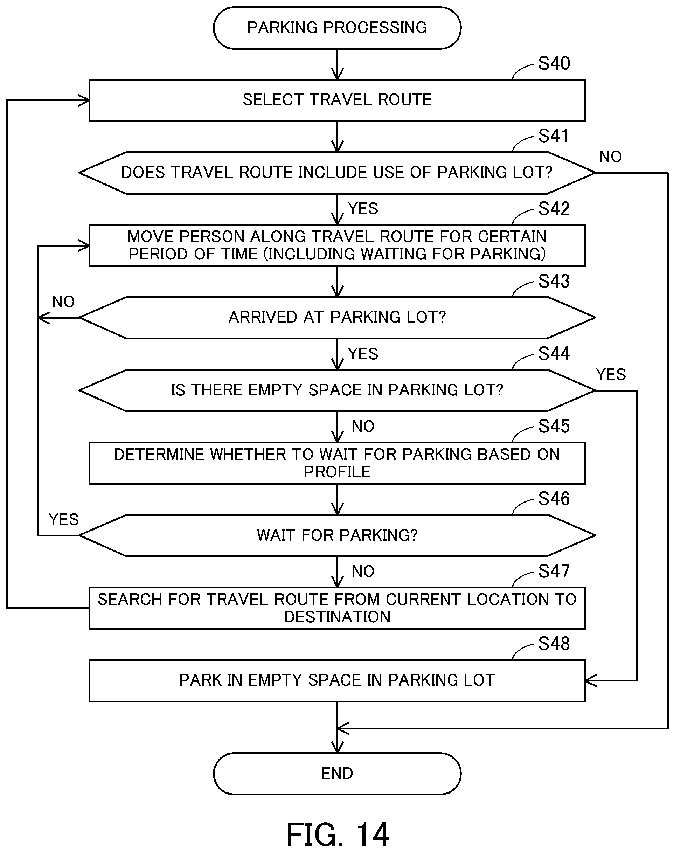

FIG. 14 is a flowchart illustrating an example of a procedure of parking processing. Here, transfer from a private car to public transportation will be described as an example of movement calculation for moving a person along a selected travel route. In step S40, the decision-making unit 126 selects a travel route. In step S41, the movement calculation unit 127 determines whether the selected travel route include the use of a parking lot. When the travel route includes the use a parking lot, the process proceeds to step S42. When the travel route does not include the use of a parking lot, the parking processing ends.

In step S42, the movement calculation unit 127 moves the person along the travel route for a certain period of time. Step S42 includes causing the person to stay at the location for a certain period of time if the person is waiting for parking. In step S43, the movement calculation unit 127 determines whether the person has arrived at the parking lot. When the person has arrived at the parking lot, the process proceeds to step S44. When the person has not yet arrived at the parking lot, the process returns to step S42.

In step S44, the movement calculation unit 127 refers to the latest state data and determines whether there is an empty space in the parking lot. When there is an empty space, the process proceeds to step S48. When there is no empty space, the process proceeds to step S45. In step S45, the movement calculation unit 127 determines whether to wait for parking based on the profile of the person. The movement calculation unit 127 may determine whether to wait for parking based on the travel purpose, age, and gender. The profile may include a preference as to whether to wait for parking.

In step S46, the movement calculation unit 127 determines whether to wait for parking. When the movement calculation unit 127 determines to wait for parking, the process returns to step S42. When the movement calculation unit 127 determines not to wait for parking, the process proceeds to step S47. In step S47, the route search unit 125 re-executes the route search to search for a travel route from the current location to the destination that does not include the parking of the private car at the current location. Then, the process returns to step S40. In step S48, the movement calculation unit 127 parks the private car in the empty space in the parking lot. Then, the parking processing ends.

As described above, the information processing apparatus 100 according to the second embodiment executes a multimodal traffic simulation that allows a person to move from a departure point to a destination while changing modes of transportation. Therefore, the information processing apparatus 100 is able to simulate the usage of a plurality of transportation modes in a certain region, and thus is able to provide information useful for city planning. In addition, the information processing apparatus 100 is able to reflect the interdependence between the selection of travel routes of a plurality of people and dynamic states of transportation modes in the multimodal traffic simulation, which improves the accuracy of the multimodal traffic simulation.

In one aspect, it is possible to improve the accuracy of traffic simulation.

## Claims

1. A computer program that causes a computer to perform a process comprising:

   searching for a plurality of travel routes (15a, 15b) along which a person moves from a departure point to a destination using one or more transportation modes among a plurality of transportation modes (13a to 13c), the one or more transportation modes being different from each other among the plurality of travel routes;
   predicting a first travel route to be selected by the person from the plurality of travel routes by using a behavior model (16) for predicting a selection behavior based on features (14a to 14c) indicating states of the plurality of transportation modes;
   simulating a first movement of the person along a time axis using the first travel route; and
   updating the features using a result of the first movement.

2. The computer program according to claim 1, wherein the first movement is a movement of the person in a first period (147-1), and the process further includes:
   predicting a second travel route to be selected by another person using the updated features, and simulating a second movement of the another person in a second period (147-2) that comes after the first period using the second travel route.

3. The computer program according to claim 1, wherein the process further includes:
   predicting the first travel route again by using the updated features, and simulating the first movement again by using the newly predicted first travel route (148-2).

4. The computer program according to claim 1, wherein the first travel route includes a transfer between different transportation modes, and
   the features (152, 154) include a congestion degree of a transfer location where the transfer between the different transportation modes takes place.

5. The computer program according to claim 1, wherein the simulating includes a human behavior simulation for simulating behaviors of a plurality of people in an area including the plurality of transportation modes by using map data that covers the area.

6. The computer program according to claim 1, wherein the simulating includes generating a first digital twin in which states of the plurality of transportation modes in a real world are reproduced in a virtual space, the real world and the virtual space being time-synchronized, and simulating behaviors of a plurality of people existing in the real world by moving a plurality of agents corresponding to the plurality of people in the generated first digital twin.

7. A traffic simulation method executed by a computer, the traffic simulation method comprising:

searching for a plurality of travel routes (15a, 15b) along which a person moves from a departure point to a destination using one or more transportation modes among a plurality of transportation modes (13a to 13c), the one or more transportation modes being different from each other among the plurality of travel routes;
predicting a first travel route to be selected by the person from the plurality of travel routes by using a behavior model (16) for predicting a selection behavior based on features (14a to 14c) indicating states of the plurality of transportation modes;
simulating a first movement of the person along a time axis using the first travel route; and
updating the features using a result of the first movement.

8. An information processing apparatus comprising:

memory means (11) for storing features (14a to 14c) indicating states of a plurality of transportation modes (13a to 13c); and
processing means (12) for
searching for a plurality of travel routes (15a, 15b) along which a person moves from a departure point to a destination using one or more transportation modes among the plurality of transportation modes, the one or more transportation modes being different from each other among the plurality of travel routes,
predicting a first travel route to be selected by the person from the plurality of travel routes by using a behavior model (16) for predicting a selection behavior based on the features,
simulating a first movement of the person along a time axis using the first travel route, and
updating the features using a result of the first movement.

FIG. 1

INFORMATION PROCESSING APPARATUS 100

CPU 101

GPU 104

DISPLAY DEVICE 111

RAM 102

INPUT INTERFACE 105

INPUT DEVICE 112

HDD 103

MEDIA READER 106

RECORDING MEDIUM 113

COMMUNI-CATION INTERFACE 107

NETWORK 114

BUS

FIG. 2

FIG. 3

141

OD DATA
GENERATION

142

ROUTE SEARCH

143

DECISION MAKING

144

MOVEMENT
CALCULATION

145

STATE UPDATE

146

INDEX OUTPUT

147-1

07:00

CYCLE
#1

07:01

147-2

07:01

CYCLE
#2

07:02

147-n

07:59

CYCLE
#N

08:00

FIG. 4

141

OD DATA
GENERATION

142

ROUTE SEARCH

143

DECISION MAKING

144

MOVEMENT
CALCULATION

145

STATE UPDATE

146

INDEX OUTPUT

148-1

07:00

CYCLE
#1

08:00

148-2

07:00

CYCLE
#2

08:00

148-n

07:00

CYCLE
#N

08:00

FIG. 5

151

| OID | Person1 | Person2 | · · · | PersonN |
|---|---|---|---|---|
| DEPARTURE TIME | 08:00 | 08:03 | · · · | 17:54 |
| DEPARTURE POINT | 60.196N, 25.723E | 59.112N, 23.457E | · · · | 57.102N, 22.984E |
| DESTINATION | 60.187N, 24.717E | 61.123N, 24.116E | · · · | 60.426N, 22.990E |
| TRAVEL PURPOSE | SOCIAL | WORK | · · · | HOME |
| GENDER | FEMALE | MALE | · · · | FEMALE |
| AGE | 25 | 36 | · · · | 40 |
| DRIVER'S LICENSE | YES | YES | · · · | NO |
| PRIVATE CAR | NO | YES | · · · | NO |

# FIG. 6

152

| PARKING LOT ID | Parking101 |
|---|---|
| NUMBER OF PARKING SPACES | 50 |
| NUMBER OF PARKED VEHICLES | 40 |
| LOCATION | 35.597N, 139.814E |
| STATE | OPEN |
| FEE | ¥300/HOUR |
| CONGESTION DEGREE | MEDIUM |

153

| LOT ID | STATE | VEHICLE ID | PARKING TIME |
|---|---|---|---|
| 1 | PARKED | Veh2 | 08:05 |
| 2 | PARKED | Veh51 | 08:03 |
| 3 | AVAILABLE | – | – |
| ... | ... | ... | ... |
| 50 | AVAILABLE | Veh7 | 07:50 |

# FIG. 7

| | | 154 |
|---|---|---|
| STATION ID | Station201 | |
| STATE | OPEN | |
| LAST UPDATE TIME | 09:00 | |
| LOCATION | 38.936N, 135.552E | |
| BARRIER-FREE | YES | |
| APPROPRIATE CAPACITY | 500 | |
| MAXIMUM CAPACITY | 750 | |
| CURRENT NUMBER OF PEOPLE | 700 | |
| CONGESTION DEGREE | HEAVY | |
| NEXT TRAIN | Line#1-905 | |

| | | 155 |
|---|---|---|
| TRAIN ID | Line#1-905 | |
| STATE | NORMAL | |
| LAST UPDATE TIME | 08:59 | |
| LOCATION | 37.225N, 133.990E | |
| BARRIER-FREE | YES | |
| NEXT STATION | Station201 | |
| WOMEN-ONLY CARRIAGE | NO | |
| NUMBER OF SEATS/ APPROPRIATE NUMBER OF PASSENGERS | 100/150 | |
| MAXIMUM NUMBER OF PASSENGER | 200 | |
| CURRENT NUMBER OF PASSENGER | 190 | |
| CONGESTION DEGREE | HEAVY | |

FIG. 8

156

| OPTION | VARIABLE | VALUE | SELECTION PROBABILITY |
|---|---|---|---|
| TRAVEL ROUTE 1 | COST $c_1$ | ¥100 | 56% |
| | TIME $t_1$ | 30 MINUTES | |
| | CONGESTION DEGREE $m_1$ | MEDIUM | |
| TRAVEL ROUTE 2 | COST $c_2$ | ¥300 | 33% |
| | TIME $t_2$ | 20 MINUTES | |
| | CONGESTION DEGREE $m_2$ | HEAVY | |
| TRAVEL ROUTE 3 | COST $c_3$ | ¥500 | 11% |
| | TIME $t_3$ | 5 MINUTES | |
| | CONGESTION DEGREE $m_3$ | LIGHT | |

# FIG. 9

INFORMATION PROCESSING APPARATUS $\qquad$ 100

OD DATA STORAGE UNIT — 121

TRAFFIC DATA STORAGE UNIT — 122

ROUTE SEARCH UNIT — 125

DECISION-MAKING UNIT — 126

SIMULATION CONTROL UNIT — 124

MOVEMENT CALCULATION UNIT — 127

STATE UPDATE UNIT — 128

STATE DATA STORAGE UNIT — 123

INDEX OUTPUT UNIT — 129

# FIG. 10

STATE DATA STORAGE UNIT 123

ROAD USAGE DATA 131

PARKING LOT USAGE DATA 132

BICYCLE PARKING LOT USAGE DATA 133

STATION USAGE DATA 134

TRAIN USAGE DATA 135

BUS STOP USAGE DATA 136

BUS USAGE DATA 137

FIG. 11

```
                    ┌──────────────────────────┐
                    │    TRAFFIC SIMULATION     │
                    └──────────────────────────┘
                                 │
                                 ▼                    ⌐S10
        ┌─────────────────────────────────────────────┐
        │         RECEIVE SIMULATION CONDITION         │
        └─────────────────────────────────────────────┘
                                 │
                                 ▼                    ⌐S11
        ┌─────────────────────────────────────────────┐
        │ RANDOMLY GENERATES OD DATA FROM SIMULATION CONDITION │
        └─────────────────────────────────────────────┘
                                 │
                                 ▼                    ⌐S12
        ┌─────────────────────────────────────────────┐
        │     INITIALIZE STATE DATA OF TRANSPORTATION  │
        └─────────────────────────────────────────────┘
                                 │
                                 ▼                    ⌐S13
        ┌─────────────────────────────────────────────┐
   ──▶  │ EXTRACT OD RECORD WHOSE DEPARTURE TIME FALLS WITHIN │
   │    │                CURRENT CYCLE                 │
   │    └─────────────────────────────────────────────┘
   │                             │
   │                             ▼                    ⌐S14
   │    ┌─────────────────────────────────────────────┐
   │    │ SEARCH FOR A PLURALITY OF TRAVEL ROUTES FOR EACH │
   │    │          OD RECORD USING STATE DATA          │
   │    └─────────────────────────────────────────────┘
   │                             │
   │                             ▼                    ⌐S15
   │    ┌─────────────────────────────────────────────┐
   │    │ CALCULATE SELECTION PROBABILITY OF EACH TRAVEL ROUTE │
   │    │               USING STATE DATA               │
   │    └─────────────────────────────────────────────┘
   │                             │
   │                             ▼                    ⌐S16
   │    ┌─────────────────────────────────────────────┐
   │    │ RANDOMLY SELECT ANY ONE OF TRAVEL ROUTE ACCORDING TO │
   │    │            SELECTION PROBABILITY             │
   │    └─────────────────────────────────────────────┘
   │                             │
   │                             ▼                    ⌐S17
   │    ┌─────────────────────────────────────────────┐
   │    │ MOVE PERSON WHO HAS NOT ARRIVED AT DESTINATION ALONG │
   │    │ SELECTED TRAVEL ROUTE FOR CERTAIN PERIOD OF TIME │
   │    └─────────────────────────────────────────────┘
   │                             │
   │                             ▼                    ⌐S18
   │    ┌─────────────────────────────────────────────┐
   │    │ UPDATE STATE DATA OF TRANSPORTATION ACCORDING TO │
   │    │                TRAVEL RESULT                 │
   │    └─────────────────────────────────────────────┘
   │                             │
   │  NO                         ▼                    ⌐S19
   └────◁ HAS CURRENT TIME REACHED END POINT OF TARGET PERIOD? ▷
                                 │ YES                ⌐S20
        ┌─────────────────────────────────────────────┐
        │ CALCULATE EVALUATION INDEX VALUE AND OUTPUT SIMULATION │
        │                   RESULT                     │
        └─────────────────────────────────────────────┘
                                 │
                                 ▼
                    ┌──────────────────────────┐
                    │           END            │
                    └──────────────────────────┘
```

FIG. 12

OD RECORD PROCESSING

S30
GENERATE OD RECORD INDICATING TRANSPORTATION DEMAND AND PROFILE OF ONE PERSON

S31
NO — DOES DEPARTURE TIME FALL WITHIN TIME PERIOD OF CURRENT CYCLE?

YES S32
SEARCH FOR TRAVEL ROUTE FROM DEPARTURE POINT TO DESTINATION USING STATE DATA

S33
CALCULATE SELECTION PROBABILITY OF EACH TRAVEL ROUTE USING STATE DATA

S34
RANDOMLY SELECT ANY ONE OF TRAVEL ROUTE ACCORDING TO SELECTION PROBABILITY

S35
MOVE PERSON ALONG SELECTED TRAVEL ROUTE FOR CERTAIN PERIOD OF TIME

S36
REFLECT USAGE OF TRANSPORTATION IN STATE DATA

S37
NO — HAS PERSON ARRIVED AT DESTINATION OR HAS CURRENT TIME REACHED END POINT OF TARGET PERIOD?

YES

END

FIG. 13

FIG. 14

# EUROPEAN SEARCH REPORT

**Application Number**

EP 25 17 2224

## DOCUMENTS CONSIDERED TO BE RELEVANT

| Category | Citation of document with indication, where appropriate, of relevant passages | Relevant to claim |
|---|---|---|
| X | US 2020/141747 A1 (KLENK MATTHEW [US] ET AL) 7 May 2020 (2020-05-07) * paragraphs [0013], [0014], [0016], [0019], [0022], [0025]; claims 15, 16 * ----- | 1-8 |

**CLASSIFICATION OF THE APPLICATION (IPC)**

INV.
G01C21/34

**TECHNICAL FIELDS SEARCHED (IPC)**

G01C

The present search report has been drawn up for all claims

| Place of search | Date of completion of the search | Examiner |
|---|---|---|
| The Hague | 26 September 2025 | Kuhn, Robert |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 17 2224

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | Publication date | Patent family member(s) | Publication date |
|---|---|---|---|
| US 2020141747 A1 | 07-05-2020 | US 2020141747 A1<br>US 2021318130 A1 | 07-05-2020<br>14-10-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160334235
- US 20170109764
- WO 2002065148 A
- JP 2023121091 A